# EUROPEAN PATENT APPLICATION

(11) **EP 4 579 508 A1**
(43) Date of publication of application: **02.07.2025**
(21) Application number: 23461707.4
(22) Date of filing: 29.12.2023
(51) Int. Cl.: G06F 30/12, G06F 30/13, G06T 17/00, G06T 19/20

(54) **A SYSTEM AND METHOD FOR GENERATING ARCHITECTURAL PLANS**

(71) Applicant: Archisnap Sp. z o.o., 60-770 Poznan (PL)
(72) Inventor: STRZYKALA, Jan, 61-545 Poznan (PL)
(74) Representative: Kancelaria Eupatent.pl Sp. z.o.o

(57) **Abstract**

A computer-implemented method for generating architectural floor plans from scans, the method comprising: (a) acquiring a point cloud (110) representing the shape of a room, generated by a room scanner (15) located at a specific location (PA, PB, PC) within the room; (b) displaying a two-dimensional (2D) cross-sectional view of the point cloud (110); (c) prompting a user to draw lines between corners of walls over the 2D view to create an annotated point cloud with user-defined corner points (212) and wall lines (211); (d) repeating steps (a), (b) and (c) for a plurality of different locations (PA, PB, PC) within the same room; (e) combining the plurality of annotated point clouds by aligning them based on the user-defined corner points (212) and wall lines (211); (f) averaging the position of user-defined corner points (212) and wall lines (211) in case of spatial misalignment; and (g) outputting the architectural floor plan comprising walls detected based on averaged positions of scan points in the vicinity of user-defined corner points (212) and wall lines (211).

## Description

### TECHNICAL FIELD

The present invention pertains to the field of computer-aided design (CAD), and more specifically, to a system and method for generating architectural plans by processing and combining point cloud data obtained from scans of building interiors and exteriors. The invention employs a specialized software interface to facilitate the creation of accurate floor plans through user interaction and data manipulation.

### BACKGROUND

The domain of architectural plan generation from interior scans has witnessed significant advancements in recent years, with the emergence of technologies such as LiDAR scanning. These technologies facilitate the capture of highly detailed point cloud data of a building's interior spaces. This data is then processed to create a two-dimensional representation of the floor plan.

One of the most common methods involves the use of densely populated point clouds to mark the positions of walls and other structural elements. Although this method is effective in capturing detailed information, it generates large datasets that are computationally demanding to manipulate and align. The process of aligning these point clouds to create a cohesive floor plan can be a complex and time-consuming task, requiring significant computational resources and expertise in data manipulation.

Another common method utilizes photogrammetry, where multiple photographs are taken from different angles and then stitched together to create a 3D model. While this method can produce highly accurate models, it is also prone to errors due to inconsistencies in lighting, camera angles, and other factors. Additionally, this method necessitates a significant amount of time and effort to capture the necessary photographs and process them into a 3D model.

In addition to these methods, there are also software solutions that aim to automate the process of generating architectural plans from interior scans. These solutions often employ machine learning algorithms to identify and mark the positions of walls and other structural elements. However, these solutions are often constrained by the quality of the input data and can struggle with complex or irregularly shaped rooms. Furthermore, these solutions often require substantial computational power and can be slow to process large or complex datasets.

Another challenge with existing methods is the potential for inaccuracies in the combined scans. Even small errors in the alignment of point clouds or the identification of structural elements can result in significant inaccuracies in the final floor plan. These inaccuracies can be difficult to identify and correct, particularly when working with large or complex datasets.

### SUMMARY OF THE INVENTION

The aim of the present invention is to address at least some of the challenges and limitations associated with existing methods of generating architectural plans from scans as discussed in the background.

Firstly, conventional methods often require the capture and processing of densely populated point cloud data to mark the positions of walls and other structural elements. This results in large datasets that are computationally demanding to handle and align. The proposed invention, on the other hand, significantly reduces the amount of data required by focusing on key landmark points defined by the user, thereby making the process more efficient and less resource-intensive.

Secondly, the accuracy of the generated floor plans in existing methods can be compromised due to potential inaccuracies in the scans. The proposed invention mitigates this issue by allowing the user to define landmarks and verify the accuracy of the scans on-site, thereby reducing the likelihood of errors.

Thirdly, current methods often make errors in scan alignment and can be time-consuming and labour-intensive, as they require the user to mark a large number of points on each scan, or let the computer do all work but most of the time result is not correct. The proposed invention simplifies this process by requiring the user to mark only a few key points, such as corners of walls, thus reducing the workload for the user and accelerating the process.

In summary, the aim of the present invention is to provide a more efficient, accurate, and user-friendly method for generating architectural plans from scans of interiors and exteriors. The invention accomplishes this by utilizing a dedicated software with a specific user interface that allows for the precise marking of key points, the combination of scans according to user-defined landmarks, and the effective handling of potential misalignments.

While existing methods for generating architectural plans from interior and exterior scans have made significant strides, they still face challenges in terms of computational complexity, processing time, and potential for inaccuracies. There is a clear need for a more efficient and accurate method for generating architectural plans from scans.

The current invention addresses these challenges by introducing a novel computer-implemented method that significantly reduces the amount of data required. By enabling the user to manually define key landmark points, such as wall corners, through a dedicated user interface, the method allows for a more efficient combination of scans. This user-defined approach not only minimizes data usage but also enhances the precision of the resulting architectural plans. The method is designed to be performed on-site, allowing immediate verification of the scans against the physical environment, which aids in detecting and correcting potential errors due to scan inaccuracies. The simplicity of the user interface and the limited number of landmarks needed for each room reduce the workload for the user, making the process of generating floor plans more efficient and user-friendly. This approach to generating architectural plans from scanned interiors and exteriors represents a significant advancement in the field of CAD, offering a practical solution for architects.

In one aspect, the present invention pertains to a computer-implemented method for generating architectural plans from scans. This method involves obtaining a point cloud from a room scanner, displaying a 2D view of the point cloud, prompting the user to draw lines between corners of walls to create an annotated point cloud, and repeating these steps for multiple locations within the room. Subsequently, the method involves combining the annotated point clouds to create a layered model, averaging the positions of user-defined corner points and wall lines in case of misalignment, and outputting the architectural floor plan. This method significantly improves the efficiency and accuracy of creating architectural plans by utilizing user input to define precise landmarks and by reducing the amount of data processed, which streamlines the combination of scans - by limiting the recognition of walls to the cloud points that are within the vicinity of the wall lines defined by the user between the corner points. In addition, the accuracy of definition of wall corners is improved, as in these areas typical point clouds in scans may contain inaccuracies.

In a specific embodiment of the invention, the 2D view is generated from cloud points at a height equivalent to the height at which the scanner was located during the scan. This feature ensures that the 2D view accurately represents the room's cross-section from the scanner's perspective, thereby facilitating more precise user annotations and enhancing the overall accuracy of the resulting architectural floor plan.

Another aspect of the invention pertains to the locations from which the point cloud is obtained, which could be within the room, at a window, or at a door. This feature enables a comprehensive representation of the room's features in the point cloud, resulting in a more complete and detailed architectural floor plan.

In another embodiment, the method includes displaying the 2D view on-site immediately after acquiring the scan. This real-time processing allows the user to directly compare the actual room with the 2D view, thereby enhancing the accuracy of the user-defined annotations and reducing the likelihood of errors.

The invention also includes an embodiment where the user can zoom into the 2D view to enable precise marking of corner points and wall lines. This zoom feature allows the user to make fine adjustments to the annotations, thereby significantly improving the accuracy of the corner points and wall lines in the architectural floor plan.

In yet another embodiment, the user is prompted to draw straight lines from one corner to another corner of a wall. This simplification of the annotation process facilitates users in defining the room's geometry, leading to a more streamlined and user-friendly experience.

Alternatively, the invention may prompt the user to draw curved lines from one corner to another corner of a wall. This feature enables the accurate representation of non-linear wall structures in the architectural floor plan, accommodating a variety of room shapes and enhancing the method's versatility.

In another aspect of the invention, the user-defined corner points and wall lines are annotated using a color different from the color of the underlying cloud points. This visual distinction allows the user to clearly see their annotations, reducing confusion and improving the clarity of the user-defined landmarks.

The method may also include an error-checking procedure that prompts the user to reevaluate the user-defined corner points and wall lines when misalignments exceed a predetermined threshold. This proactive approach to error management ensures that inaccuracies are promptly addressed, maintaining the integrity of the architectural floor plan.

In another embodiment, the averaging of positions includes a graphical representation of the misalignment and the corrected alignment for user verification. This visual feedback allows users to understand and confirm the adjustments made to the corner points and wall lines, promoting transparency and trust in the method's accuracy.

Furthermore, the architectural floor plan output includes metadata for each structural element based on the user-defined corner points and wall lines. This metadata addition enriches the floor plan with valuable information that can be used for further analysis, planning, or documentation, thereby enhancing the utility of the generated architectural floor plan.

In another aspect, the invention relates to a computer-implemented system for generating architectural plans from scans. The system comprises: an interface to a scanning device configured to obtain from the scanning device a point cloud representing a shape of a room by scanning the room from a plurality of different locations within the room; at least one nontransitory processor-readable storage medium that stores processor-executable instructions and data; and at least one processor communicably coupled to at least one nontransitory processor-readable storage medium, wherein at least one processor is configured to perform the steps of the method as described herein.

In another aspect, the invention relates to a computer program product for generating architectural plans from scans, comprising computer-readable instructions which, when executed on a computer system, cause the computer to perform the method as described herein.

These and other features, aspects and advantages of the invention will become better understood with reference to the following drawings, descriptions, and claims.

### BRIEF DESCRIPTION OF DRAWINGS

The invention is illustrated by means of an example embodiment in a drawing, wherein:
Fig. 1 shows an embodiment of carrying out the method according to the invention;
Fig. 2 shows an example representation of a room to be scanned;
Fig. 3A shows a scan made from a first location within the room;
Fig. 3B shows a scan made from a second location within the room;
Fig. 3C shows a scan made from a location at a door;
Fig. 4 shows a user interface for prompting a user to draw lines;
Fig. 5 shows a zoom-in functionality;
Fig. 6 shows an example representation of combined annotated scans;
Fig. 7 shows a zoom-in functionality for indicating misalignment;
Fig. 8 shows an example of a generated floor plan including multiple rooms;

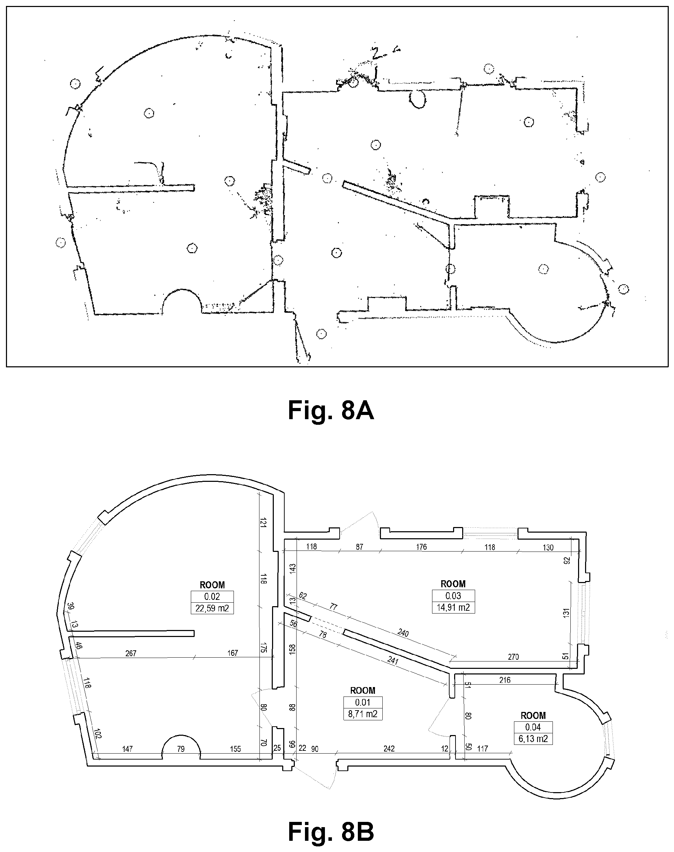

Fig. 8 shows an example of a computer system for implementing the invention.

### DETAILED DESCRIPTION OF AN EMBODIMENT

The following detailed description represents the best currently contemplated modes of carrying out the invention. This description is not to be taken in a limiting sense, but is made merely for the purpose of illustrating the general principles of the invention.

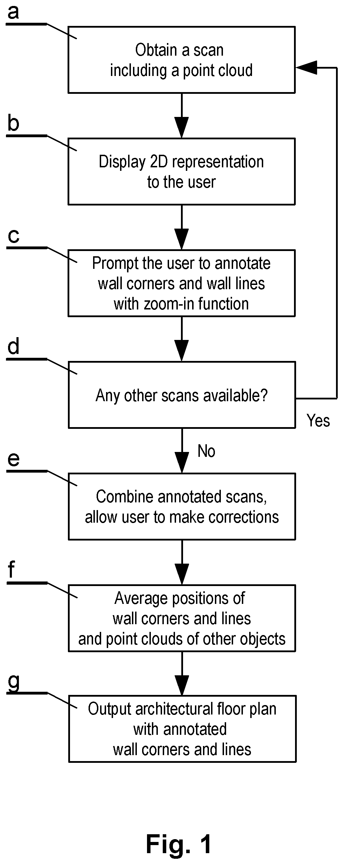

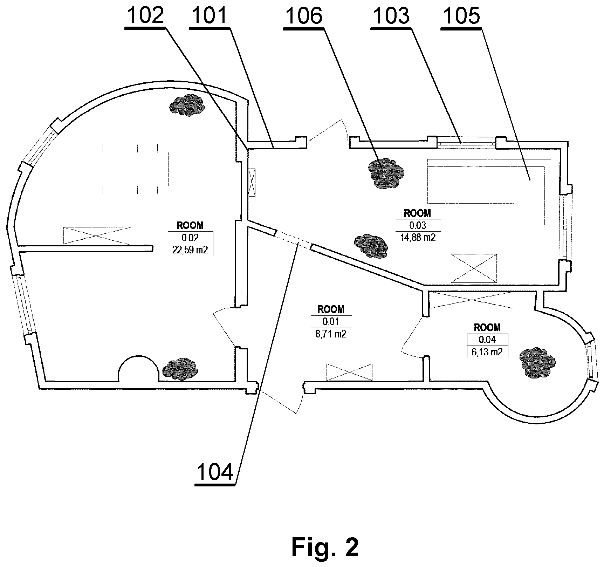

The method, according to an embodiment of the invention shown in Fig. 1, commences with step (a), which involves receiving a room scan, as illustrated in Fig. 2, from a specific location within the room. The scan takes the form of a point cloud, represented in a standard file format for such data, and is received from a conventional room scanner.

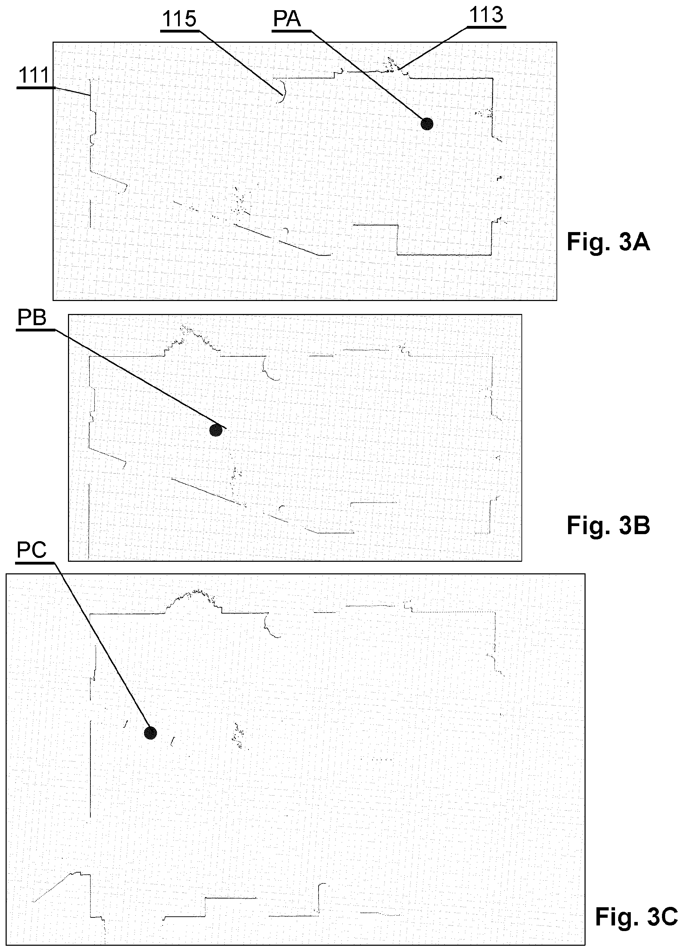

In step (b), a 2D view of the point cloud is displayed to the user on a screen, such as shown in Fig. 3A. The display presents the point cloud data in a cross-section at a specific height, for instance, at the height at which the scanner was installed. The scanner can be either a 2D scanner, which directly outputs the 2D scan, or a 3D scanner, which outputs a spatial point cloud. From this point cloud, the 2D cross-section is extracted by the scanner software or by the software of the present system in step 12 as a data pre-processing step.

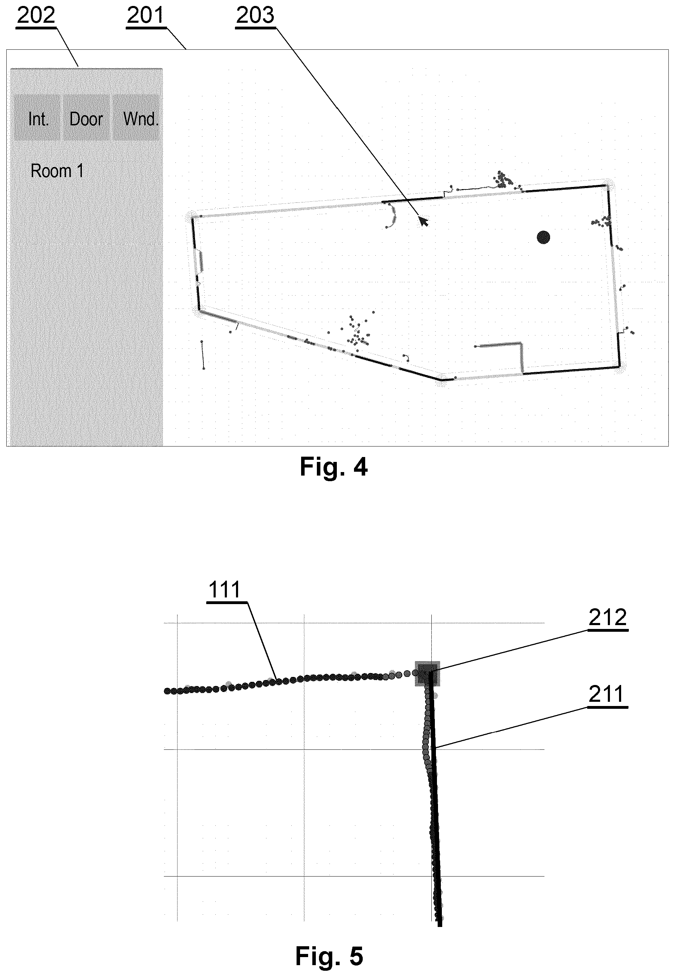

In step (c), a user interface is provided, as illustrated in Fig. 4, prompting the user to point at wall corners in the 2D view, in order to indicate the expected positions of wall lines. A corner is understood to be a point belonging to the wall at which the wall changes its direction - such as a point at which two walls begin at a 90 degree angle from each other, but it can be also a point at which two straight wall sections adhere to each other. A wall line is then defined between the wall corners defined by the user - typically, a straight line, but the user may also define (using standard drawing interfaces) a curved line. The user may zoom in for precise marking, as shown in Fig. 5. The output of this step is an annotated scan, wherein the algorithm can annotate types of objects, such as walls (between user-defined corners), furniture or plants.

In step (d), the system checks for the availability of other scans. If available, steps 11-13 are repeated for the other scans until all scans (corresponding to a single room or all rooms within the floor for which the architectural plan is to be created) are processed.

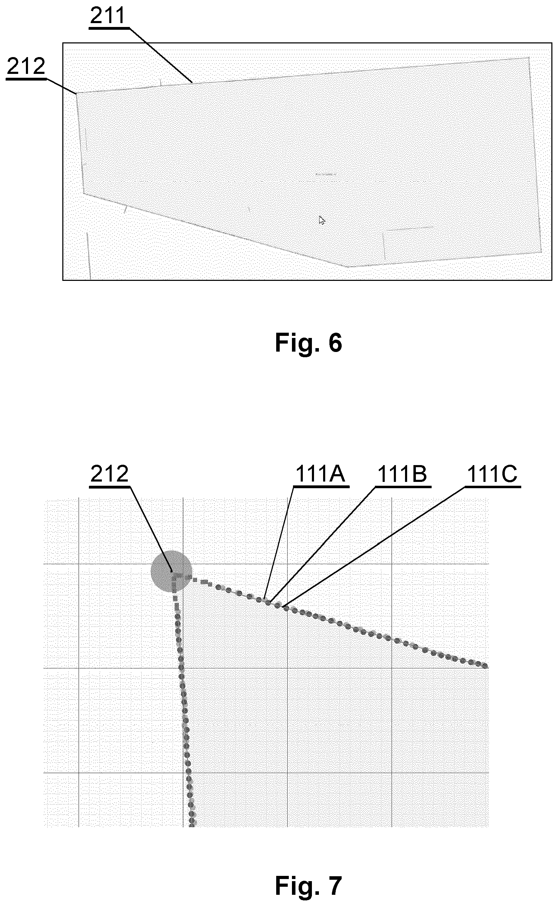

In step (e), the annotated point clouds are combined into a layered model, with each layer corresponding to a particular annotated scan. The combination is performed based on the user-annotated position of the wall corners, and therefore also corresponding walls. This significantly simplifies the computational effort, as the algorithm does not need to process all points of the scan, but only points in the vicinity of the corners and walls as defined by the user. If the misalignment is significant (for example, if scan points corresponding to a wall deviate more than 4 centimeters from the user-defined wall line), it can be visualized to the user, as shown in Fig. 7, enabling the user to verify the appropriateness of the averaged positions and make corrections if necessary.

In step (f), the positions of user-defined corner points, wall lines, and other cloud points are averaged in the event of their misalignment to form a model, as shown in Fig. 6.

In step (g), the final architectural floor plan is output, comprising walls detected based on averaged positions of scan points in the vicinity of user-defined corner points, as shown in Fig. 8A. This can be then converted to a vector model for use in architectural CAD systems, as shown in Fig. 8B, using well known methods for modeling point clouds.

Fig. 2 shows an example representation of a room to be scanned. The room is bounded by walls 101 that terminate at corners 102. The walls contain windows 103 and doors 104. Within the room, there are several objects, such as furniture 105 or plants 106. A skilled practitioner will understand that to scan the room, a room scanner, such as a LiDAR scanner, should be located at least in locations PA, PB, and PC to ensure each wall is visible on at least one scan.

Fig. 3A shows a scan made from a first location PA within the room. The point cloud data 110 represents cloud points of a 2D cross-sectional view at the height of the scanner located at location PA. It can be observed that some of the cloud points along the walls 111 are not arranged along a straight line due to measurement inaccuracies. Cloud points 113 at the windows may appear at random positions outside the windows. Some fragments of the room are not visible, as they are obstructed by the objects within the room represented by points 115. Fig. 3B and Fig. 3C show corresponding scans made from locations PB and PC. Performing the scan at location PC within the doorway allows for precise marking of the door location and facilitates combining scans of adjacent rooms to create the whole floorplan, since the scan from location PC includes both the room visible in scans made from locations PA and PB, as well as the adjacent room.

Fig. 4 shows a user interface 201 for prompting a user to draw lines. It shows the 2D point cloud 110 with an overlay that allows the user to draw or annotate directly onto the point cloud. The interface includes a standard user interface toolbox 202 with identifier of a room that is currently annotated (Room 1), selection buttons for selecting the type of scan based on the scanner's position (Int. - within room interior; Wnd. - at the window; Door - at the door (wherein typically more than one room is visible)) and also tools for drawing straight or curved lines, zooming in for precision, and possibly color-coding for different structural elements. The user has a pointer 203 by which the positions of the objects to be drawn are indicated. The interface should have usability typical for CAD software systems. The annotated objects may have different colors. For example:
- annotated wall lines - marked in violet;
- annotated corners - marked in yellow;
- furniture - marked in orange;
- noisy points, such as outside windows - marked in blue;
- unrecognized points, suspected as being noise - marked in red;

Fig. 5 shows a zoom-in functionality provided by the user interface. It is a close-up view of a portion of the point cloud with wall points 111, demonstrating how a user can zoom in to precisely mark corner points 212 and wall lines 211. The figure should highlight the increased level of detail visible when zoomed in, allowing for accurate placement of annotations.

Fig. 6 shows an example representation of combined annotated scans. It illustrates multiple scans from Figs. 2A, 2B, and 2C that are aligned and layered to create a comprehensive model of the room, indicating the user-defined corner points 212 and wall lines 211.

Fig. 7 shows the zoom-in functionality for detecting misalignment. It indicates an area where scans do not perfectly align, with graphical representations of the misalignment between points 111A and 111B and the averaged alignment 111C represented as a continuous line. In addition, since the user has defined a precise position of the corner point 212, the wall line 111C may be automatically extended up to the corner point in case the point cloud contains less data in the vicinity of the corner. The user interface includes tools that allow moving the averaged alignment 11C to a position desired by the user.

Fig. 8A shows a final result of combination and averaging of all scans and Fig. 8B shows the entire floorplan output by the system.

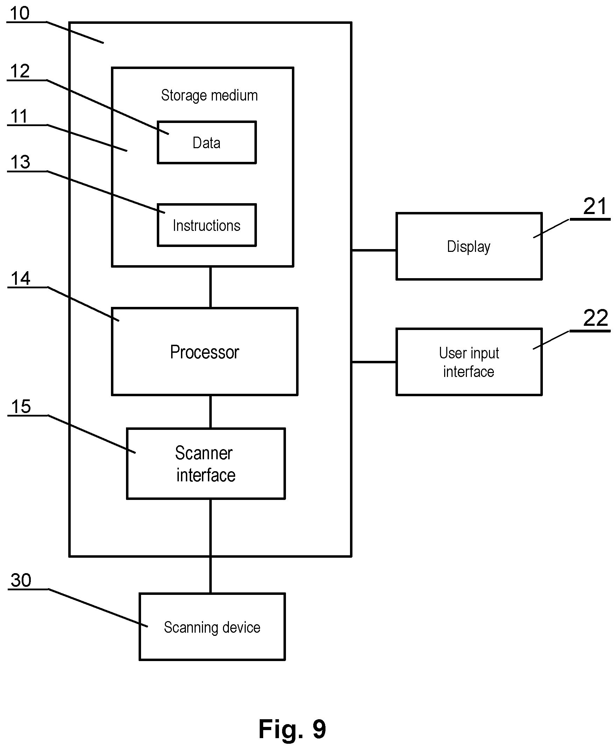

The method can be implemented in a computer system 10 as shown in Fig. 9. The system 10 may include at least one nontransitory processor-readable storage medium 11 that stores at least one of processor-executable instructions 12 or data 13; and at least one processor 14 communicably coupled to the at least one nontransitory processor-readable storage medium 11. The at least one processor 14 may be configured to (by executing the instructions 13) perform the procedure of Fig. 1. The data 12 includes scans collected from the scanning device 30, user-annotated scans generated during the procedure, and a generated output architectural floor plan. A display 21 is connected to the system 10 to display the user interface elements and allow the user to input data via input means 22, such as a mouse or touchpad of a laptop computer. The computer system includes a scanner interface 15, such as a wired (e.g., USB) or wireless (e.g., WiFi) interface to connect with a scanning device 30. The scanning device may be a standard room scanner, such as a LiDAR scanner, or a scanner dedicated to the present system. For example, a dedicated scanner may include a large touch display via which the user interface elements are displayed instead of the computer screen 21 and a touchpad 22 of a laptop.

While the invention has been described with respect to a limited number of embodiments, it will be appreciated that many variations, modifications, and other applications of the invention may be made. Therefore, the claimed invention, as recited in the claims that follow, is not limited to the embodiments described herein.

## Claims

1. A computer-implemented method for generating architectural plans from scans, the method comprising:
(a) acquiring a point cloud (110) representing the shape of a room, generated by a room scanner (15) located at a specific location (PA, PB, PC) within the room;
(b) displaying a two-dimensional (2D) cross-sectional view of the point cloud (110);
(c) prompting a user to draw lines between corners of walls over the 2D view to create an annotated point cloud with user-defined corner points (212) and wall lines (211);
(d) repeating steps (a), (b) and (c) for a plurality of different locations (PA, PB, PC) within the same room;
(e) combining the plurality of annotated point clouds by aligning them based on the user-defined corner points (212) and wall lines (211);
(f) averaging the position of user-defined corner points (212) and wall lines (211) in case of spatial misalignment;
(g) outputting the architectural floor plan comprising walls detected based on averaged positions of scan points in the vicinity of user-defined corner points (212) and wall lines (211).

2. The method of claim 1, wherein the 2D view is generated from cloud points (110) at a height equivalent to the height at which the scanner (15) was installed during performing the scan.

3. The method of claim 1, wherein the scan relates to a building interior and the locations (PA, PB, PC) include locations within a room interior, at a window, and at a door.

4. The method of claim 1, wherein step (b) is performed on-site after the scan is acquired in step (a).

5. The method of claim 1, further comprising, in step (c), allowing the user to zoom into the 2D view for precise marking of corner points and wall lines.

6. The method of claim 1, wherein in step (c) the user is prompted to draw a straight line from one corner to another corner of a wall.

7. The method of claim 1, wherein in step (c) the user is prompted to draw curved lines from one corner to another corner of a wall.

8. The method of claim 1, wherein in step (c) the user-defined corner points and wall lines are annotated using a color distinct from the color of the underlying cloud points.

9. The method of claim 1, further comprising an error-checking procedure in step (e) that prompts the user to reassess the user-defined corner points and wall lines if misalignments exceed a predetermined threshold.

10. The method of claim 1, wherein in step (f) the averaging process includes a graphical representation of the misalignment and the corrected alignment for user verification.

11. The method of claim 1, wherein the architectural floor plan outputted in step (g) includes metadata for each structural element detected.

12. A computer-implemented system (10) for generating architectural plans from scans, the system comprising:
- an interface (15) to a scanning device configured to acquire from the scanning device a point cloud representing a room's shape by scanning the room from multiple different locations;
- at least one nontransitory processor-readable storage medium (11) that stores processor-executable instructions (12) and data (13); and
- at least one processor (14) communicably coupled to at least one nontransitory processor-readable storage medium (11), wherein at least one processor (14) is configured to perform the steps of the method of any of claims 1-11.

13. A computer program product for generating architectural plans from scans, comprising computer-readable instructions which when executed on a computer system cause the computer to perform the method of any of claims 1-11.
